(19) Europäisches Patentamt / European Patent Office / Office européen des brevets

(11) **EP 3 174 107 A1**

(12) **DEMANDE DE BREVET EUROPEEN**

(43) Date de publication:
**31.05.2017 Bulletin 2017/22**

(51) Int Cl.:
**H01L 31/055** (2014.01)

(21) Numéro de dépôt: **15196313.9**

(22) Date de dépôt: **25.11.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA MD**

(71) Demandeur: **AGC Glass Europe**
**1348 Louvain-la-Neuve (BE)**

(72) Inventeurs:
• **LAMBRICHT, Thomas**
  **1360 Perwez (BE)**
• **POOT, Benoît**
  **7850 Petit-Enghien (BE)**
• **DOMERCQ, Benoît**
  **1420 Braine-L'Alleud (BE)**

(74) Mandataire: **Bayot, Daisy et al**
**AGC Glass Europe**
**Technovation Centre**
**IP Department**
**Rue Louis Blériot, 12**
**6041 Gosselies (BE)**

(54) **DISPOSITIF PHOTOVOLTAIQUE**

(57) L'invention concerne un dispositif photovoltaïque, destiné à convertir en électricité un rayonnement incident $\phi 1$ d'une longueur d'onde $\lambda 1$ comprise entre 280 et 1000 nm, comprenant (i) un assemblage comprenant une feuille de verre présentant deux faces principales f1 et f2, la face f1 étant celle par laquelle pénètre le rayonnement incident dans ledit assemblage et ladite feuille étant transparente audit rayonnement incident $\phi 1$ ; et une couche fonctionnelle recouvrant la face principale f2 de la feuille et comprenant une matrice dans laquelle sont dispersés des éléments luminescents susceptibles d'absorber ledit rayonnement incident $\phi 1$ de longueur d'onde $\lambda 1$ et de le réémettre avec une longueur d'onde $\lambda 2$ supérieure à $\lambda 1$ et comprise entre 800 et 1400 nm; et (ii) au moins une cellule photovoltaïque sur laquelle parvient le rayonnement réémis de longueur d'onde $\lambda 2$ et qui est sensible à la longueur d'onde $\lambda 2$. Dans ce dispositif, la feuille de verre présente un coefficient d'absorption à la longueur d'onde $\lambda 2$ inférieur à 3 m$^{-1}$. Un tel dispositif trouve une application dans la récupération d'énergie solaire dans le domaine du bâtiment.

FIG.1

EP 3 174 107 A1

**Description**

## 1. Domaine de l'invention

La présente invention concerne de manière générale un dispositif capable de convertir un rayonnement incident, notamment solaire, en électricité au moyen de cellules solaires (ou photovoltaïques), et plus particulièrement à un dispositif de ce type qui collecte et concentre de façon plus efficace le rayonnement incident pour l'utilisation par ces cellules. En particulier, l'invention concerne un dispositif photovoltaïque (PV) comportant une ou plusieurs cellule(s) photovoltaïque (s) et un assemblage d'au moins une feuille de verre transparente au rayonnement incident, et d'une matrice dans laquelle sont dispersés des éléments luminescents susceptibles d'absorber le rayonnement incident et de le réémettre avec une longueur d'onde supérieure, de manière à ce que la longueur d'onde du nouveau rayonnement tombe dans la zone de sensibilité de la ou des cellule(s) photovoltaïque(s) dont la surface est bien inférieure à celle de chaque face principale (surface productrice <<< surface collectrice).

Un tel dispositif trouve essentiellement, mais pas seulement, une application dans la récupération d'énergie solaire dans le domaine du bâtiment (dispositif du type « Building-integrated photovoltaics » ou « BIPV »).

## 2. Solutions de l'art antérieur

Des dispositifs concentrateurs de rayonnement sont connus depuis très longtemps et par exemple, certains sont déjà décrits dans les brevets EP0004242B1, DE2628291 et US4127425.

De plus, dans l'article de E. WEBER et J. LAMBE publié dans «Applied Optics» volume 15, n°10 pages 2299-2300, il est décrit un collecteur de rayonnement disposé dans une enceinte dont la surface supérieure est une fenêtre en verre ou en plastique et la surface inférieure est un miroir.

Le brevet EP0004242B décrit un concentrateur de rayonnement solaire où le rayonnement ($\lambda$1) traverse une matrice dans laquelle sont reparties des substances fonctionnant en cascade lumineuse capables d'absorber de l'énergie dans un domaine de longueurs d'ondes ($\lambda$1) et de la réémettre dans un domaine de longueurs d'ondes plus grandes ($\lambda$2) et correspondant à la zone de sensibilité optimale d'une cellule photovoltaïque solaire sur laquelle parvient ledit rayonnement dont l'énergie utile est ainsi amplifiée, où ladite matrice est située dans une enceinte dont une partie au moins, par laquelle pénètre ledit rayonnement avant de traverser ladite matrice, est constituée d'une substance ayant un premier indice de réfraction (n1) du côté de l'extérieur de l'enceinte, et un second indice de réfraction (n2) du côté de ladite matrice, ledit second indice étant aussi élevé que possible par rapport audit premier indice, le reste de ladite enceinte étant opaque audit rayonnement parvenant aux cellules photovoltaïques situées également dans l'enceinte.

Le brevet DE2628291 décrit un dispositif pour convertir l'énergie solaire en énergie électrique, dans lequel la lumière incidente est capturée dans une couche transparente ou «concentrateur» d'indice de réfraction plus grand que celui du milieu environnant et contenant des « centres fluorescents »; la lumière réémise va ensuite vers des cellules solaires classiques.

Le brevet US4127425 décrit un dispositif collecteur de rayonnement se composant d'une couche plane luminescente et d'une cellule solaire disposée sur une des faces latérales, la couche est constituée par une matrice dans laquelle un ou plusieurs agents luminescents sont répartis. Les autres faces latérales et la face inférieure peuvent être recouvertes de miroirs. Un rayonnement incident à la face supérieure est absorbé et réémis dans un angle de $4\pi$. Par réflexions internes successives, un flux intense de lumière de la longueur d'onde désirée est alors canalisé vers l'extrémité recouverte par la cellule. Les couches planes luminescentes peuvent être constituées de verre ou d'un matériau polymère dans lequel des agents luminescents sont dispersés. Ces agents peuvent émettre directement la lumière dont l'énergie est voisine de la gamme à laquelle la cellule solaire est sensible ; ils peuvent également émettre celle-ci au moyen d'un phénomène de cascade. De plus, dans le dispositif de US4727425, la ou les cellules photovoltaïques sont positionnées sur une tranche de la couche luminescente qui a été élargie de manière à augmenter la surface de ladite tranche et permettre l'utilisation de cellules de plus grandes surface et ainsi d'obtenir une surface productrice augmentée.

Dans tous les dispositifs de la technique antérieure, l'absorption du rayonnement incident et/ou la réémission du nouveau rayonnement se situe(nt) au moins en partie dans le domaine du visible donnant ainsi au dispositif une couleur en transmission et/ou absorption qui n'est souvent pas souhaitable dans des applications architecturales. De plus, ces dispositifs connus n'ont qu'une surface très modeste (de l'ordre de 100 cm$^2$) et/ou une efficacité très faible à modérée et/ou une stabilité relative dans le temps (surtout du fait de l'utilisation de luminophores organiques) et/ou ne sont pas suffisamment transparents dans le visible.

Afin de rendre tous ces dispositifs connus réellement envisageables dans des applications architecturales, il est primordial d'augmenter significativement leur taille, typiquement de l'ordre de 1m par 2m, voire 2m par 4m (ou même plus). De telles dimensions génèrent alors, si on considère les dispositifs connus, une perte significative de l'énergie du rayonnement réémis par absorption dans le matériau du dispositif et dès lors, le rendement du dispositif s'en trouve extrêmement diminué.

Si on considère le verre comme matériau transparent de choix dans de tels dispositifs, il est clair que ce phénomène d'absorption du rayonnement réémis est critique lorsqu'on souhaite augmenter la surface vitrée, jusqu'à atteindre une taille suffisamment grande pour des applications en bâtiment notamment.

De plus, afin d'éviter le domaine du visible pour les raisons précitées, il serait avantageux que les rayonnements absorbés et/ou réémis se situent dans le domaine des UV ou du proche infrarouge. Dans le cas d'une conversion vers des longueurs d'onde plus grandes, il sera judicieux d'utiliser le domaine du proche infrarouge pour le rayonnement réémis. Ainsi, si on considère le verre sodo-calcique classique et dit « clair » comme matériau transparent dans de tels dispositifs, celui-ci présente un coefficient d'absorption de 30 m$^{-1}$ à la longueur d'onde de 850 nm. La conséquence d'un tel coefficient d'absorption est qu'après seulement 2,3 cm de trajet dans le verre, 50% du rayonnement réémis est déjà réabsorbé et, après seulement 5,3 cm de trajet dans le verre, il reste moins de 1% du rayonnement initialement réémis. Le verre sodo-calcique dit « extra-clair », à basse teneur en fer, présente, quant à lui, un coefficient d'absorption de 4 m$^{-1}$ à la longueur d'onde de 850 nm. La conséquence d'un tel coefficient d'absorption est qu'après seulement 23 cm de trajet dans le verre, 50% du rayonnement réémis est déjà réabsorbé et après 115 cm de trajet dans le verre, il reste moins de 1% du rayonnement initialement réémis.

Une des solutions pour résoudre ce problème majeur serait d'augmenter la surface productrice (donc le nombre et/ou la taille des cellules photovoltaïques). Dans des dispositifs PV classiques, augmenter la surface productrice entraîne automatiquement une augmentation drastique du coût total du dispositif et, potentiellement, nécessite l'envahissement des faces principales de la matrice (par manque de place sur ses tranches) ce qui, forcément, impacte alors de façon cruelle l'esthétique générale du dispositif PV qui perd au moins partiellement sa transparence (comme c'est le cas de dispositifs BIPV classiques comportant des zones opaques correspondant aux cellules solaires en faces principales). Le dispositif du brevet US4727425 tente de contourner cet inconvénient en augmentant spécifiquement et localement l'épaisseur de la tranche de la matrice luminescente et permettant une surface de cellules solaires plus élevées mais (i) l'impact négatif sur le coût est toujours présent par rapport à la solution précédente et (ii) l'augmentation locale de l'épaisseur d'une tranche ne peut se faire aisément avec tous les types de substrat/matrice (et certainement pas dans le cas d'une matrice transparente faite de verre).

Il y a donc une demande de proposer, sur le marché du photovoltaïque, un vitrage pour application BIPV qui est efficace, transparent dans le visible et de grandes dimensions.

### 3. Objectifs de l'invention

L'invention, dans au moins un de ses modes de réalisation, a pour objectif de fournir un dispositif photovoltaïque permettant de remédier aux inconvénients des dispositifs PV de l'art antérieur.

En particulier, l'invention, dans au moins un de ses modes de réalisation, a pour objectif de fournir un dispositif photovoltaïque permettant de réduire très fortement les pertes de rayonnement réémis par absorption.

L'invention, dans au moins un de ses modes de réalisation, a également pour objectif de fournir un dispositif photovoltaïque utilisant un rayonnement réémis invisible à l'oeil.

Un autre objectif de l'invention, dans au moins un de ses modes de réalisation, est de fournir un dispositif photovoltaïque qui permet de maintenir la transparence dudit dispositif lorsqu'il est vu de ses faces principales.

Finalement, l'invention a également pour objectif de fournir un dispositif photovoltaïque concentrateur qui est peu onéreux à produire.

### 4. Exposé de l'invention

L'invention concerne un dispositif photovoltaïque, destiné à convertir en électricité un rayonnement incident $\phi$1 d'une longueur d'onde $\lambda$1 comprise entre 280 et 1000 nm, comprenant :

(i) un assemblage comprenant

- une feuille de verre V1 présentant deux faces principales f1 et f2, la face f1 étant celle par laquelle pénètre le rayonnement incident $\phi$1 dans l'assemblage et ladite feuille V1 étant transparente audit rayonnement incident $\phi$1 ;
- une couche fonctionnelle F recouvrant la face principale f2 de la feuille V1 et comprenant une matrice dans laquelle sont dispersés des éléments luminescents susceptibles d'absorber ledit rayonnement incident $\phi$1 de longueur d'onde $\lambda$1 et de le réémettre avec une longueur d'onde $\lambda$2 supérieure à $\lambda$1 et comprise entre 800 et 1400 nm;

(ii) au moins une cellule photovoltaïque (C1, C2, C3, ...) sur laquelle parvient le rayonnement réémis de longueur d'onde $\lambda$2 et qui est sensible à la longueur d'onde $\lambda$2 ;

dispositif dans lequel la feuille de verre V1 présente un coefficient d'absorption à la longueur d'onde $\lambda 2$ inférieur à 3 m$^{-1}$.

Ainsi, l'invention repose sur une approche tout à fait nouvelle et inventive. Les inventeurs ont en effet mis en évidence qu'il était possible d'obtenir un dispositif PV très efficace permettant d'atteindre si désiré la transparence nécessaire aux applications bâtiments et conservant son efficacité même pour des dimensions très grandes (de l'ordre de plusieurs mètres), en combinant, dans un assemblage, une feuille de verre associée à une couche fonctionnelle comportant des éléments luminescents susceptibles d'absorber un rayonnement incident de longueur d'onde $\lambda 1$ et de le réémettre avec une longueur d'onde $\lambda 2$ supérieure à $\lambda 1$ et située entre 800 et 1400 nm; la feuille de verre étant hautement transmissive à la longueur d'onde $\lambda 2$.

Dans l'invention, cet assemblage particulier feuille de verre-couche fonctionnelle joue le rôle de guide d'onde très efficace pour le rayonnement réémis de manière isotrope par les éléments luminescents, de façon à tirer profit au maximum de ce nouveau rayonnement et d'en récupérer un maximum d'énergie valorisable par les cellules photovoltaïques. Dès lors, des avantages certains apparaissent; en premier lieu, les cellules photovoltaïques peuvent être, à puissance égale, réduites en nombre/surface puisque le rendement du dispositif est amélioré par rapport à des dispositifs PV de l'état de la technique, ce qui permet de réduire le coût du dispositif et/ou de trouver suffisamment de place sur la tranche de l'assemblage afin d'y positionner les cellules, ce qui permet alors d'obtenir un dispositif « transparent » valorisable en tant que vitrage architectural.

Dans l'ensemble du présent texte, lorsqu'une gamme est indiquée, les extrémités sont incluses. En outre, toutes les valeurs entières et sous-domaines dans une gamme numérique sont expressément inclus comme si explicitement écrits. Dans l'ensemble du présent texte également, les valeurs de teneur sont en pourcentages sauf précision contraire explicite (par exemple, en ppm). De même, dans l'ensemble du présent texte également, toutes les valeurs de teneur en pourcentages sont pondérales (en poids), c'est-à-dire exprimées par rapport au poids total du verre.

D'autres caractéristiques et avantages de l'invention apparaîtront plus clairement à la lecture de la description suivante, des exemples et des figures parmi lesquelles :

- la figure 1 représente un schéma du dispositif selon l'invention ;
- la figure 2 est une variante d'exécution du dispositif de la figure 1 ;
- la figure 3 est une variante d'exécution du dispositif de la figure 1 ;
- la figure 4 est une variante d'exécution du dispositif de la figure 2 ;
- la figure 5 est une variante d'exécution du dispositif de la figure3 ;
- la figure 6 est une variante d'exécution du dispositif de la figure 1 ;
- la figure 7 est une variante d'exécution du dispositif de la figure 1 ;
- la figure 8 est une variante d'exécution du dispositif de la figure 2.

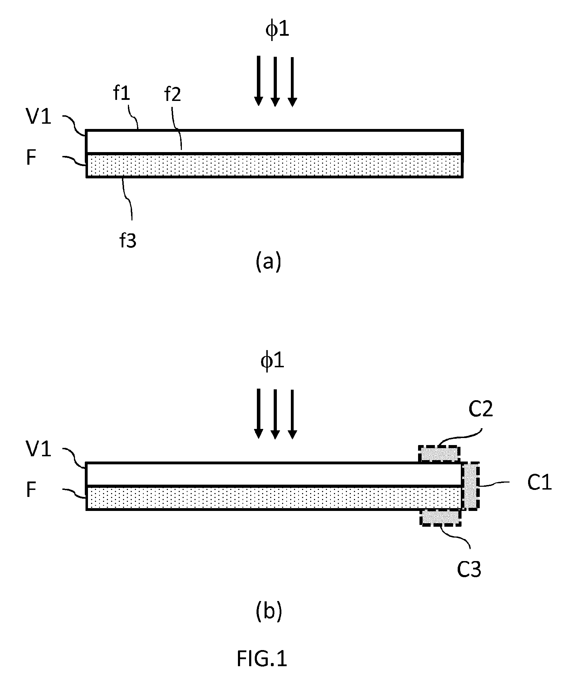

L'assemblage selon l'invention, illustré à la figure 1(a), comprend :

- une feuille de verre V1 présentant deux faces principales f1 et f2, la face f1 étant celle par laquelle pénètre le rayonnement incident dans l'assemblage et ladite feuille V1 étant transparente audit rayonnement incident $\phi 1$ ;
- une couche fonctionnelle F recouvrant la face f2 de la feuille V1 et comprenant une matrice dans laquelle sont dispersés des éléments luminescents (EL) susceptibles d'absorber ledit rayonnement incident $\phi 1$ de longueur d'onde $\lambda 1$ et de le réémettre avec une longueur d'onde $\lambda 2$ supérieure à $\lambda 1$ et comprise entre 800 et 1400 nm.

L'assemblage selon l'invention illustré à la figure 1 comprend deux faces principales externes f1 et f3 et des faces secondaires correspondant aux tranches de l'assemblage et qui sont de surface significativement plus petite par rapport à la surface desdites faces principales f1 et f3.

La feuille de verre V1 selon l'invention est transparente au rayonnement incident $\phi 1$ de longueur d'onde $\lambda 1$. Par transparente au rayonnement incident $\phi 1$ selon l'invention, on entend que la feuille de verre présente une transmission de la longueur d'onde $\lambda 1$ supérieure à 10%.

La feuille de verre V1 peut être une feuille de verre obtenue par un procédé de flottage, d'étirage, de laminage ou tout autre procédé connu pour fabriquer une feuille de verre au départ d'une composition de verre en fusion. Préférentiellement, la feuille de verre V1 est une feuille de verre flotté. La feuille de verre V1 peut avoir une épaisseur variant entre 0,1 et 25 mm. Avantageusement, la feuille de verre V1 selon l'invention peut avoir une épaisseur entre 4 et 12 mm. La feuille de verre V1 selon l'invention est faite de verre pouvant appartenir à diverses catégories en terme de composition de base. Le verre peut ainsi être un verre de type silico-sodo-calcique, alumino-silicate, boro-silicate,... De manière préférée, la composition de base de la feuille de verre V1 comprend en une teneur exprimée en pourcentages en poids total de verre :

| | |
|---|---|
| $SiO_2$ | 55 - 85% |
| $Al_2O_3$ | 0 - 30% |
| $B_2O_3$ | 0 - 20% |
| $Na_2O$ | 0 - 25% |
| CaO | 0 - 20% |
| MgO | 0 - 15% |
| $K_2O$ | 0 - 20% |
| BaO | 0 - 20%. |

De manière toute préférée, la composition de base de la feuille de verre V1 comprend en une teneur exprimée en pourcentages en poids total de verre :

| | |
|---|---|
| $SiO_2$ | 55 - 78% |
| $Al_2O_3$ | 0 - 18% |
| $B_2O_3$ | 0 - 18% |
| $Na_2O$ | 0 - 20% |
| CaO | 0 - 15% |
| MgO | 0 - 10% |
| $K_2O$ | 0 - 10% |
| BaO | 0 - 5% |

De manière la plus préférée et pour des raisons de coûts plus faibles de production, la feuille de verre V1 selon l'invention est une feuille de verre silico-sodo-calcique. Avantageusement, selon ce mode de réalisation, la composition de base de la feuille de verre V1 comprend, en une teneur exprimée en pourcentages en poids total de verre :

| | |
|---|---|
| $SiO_2$ | 60 - 75% |
| $Al_2O_3$ | 0 - 6% |
| $B_2O_3$ | 0 - 4% |
| CaO | 0 - 15% |
| MgO | 0 - 10% |
| $Na_2O$ | 5 - 20% |
| $K_2O$ | 0 - 10% |
| BaO | 0 - 5%. |

En plus de sa composition de base, la feuille de verre V1 peut comprendre d'autres composants, de nature et de quantité adaptées en fonction de l'effet recherché.

Selon l'invention, la feuille de verre V1 a avantageusement un coefficient d'absorption à la longueur d'onde λ2, comprise entre 800 à 1400 nm, très faible comparé à des verres usuels (comme le verre dit « clair » ou même « extra-clair »).

Pour quantifier la bonne transmission du verre dans le domaine des infrarouges à des longueurs d'onde spécifiques et d'intérêt pour les applications concernées, dans la présente description, on utilisera le coefficient d'absorption à la longueur d'onde d'intérêt, c'est-à-dire à la longueur d'onde de réémission des éléments luminescents (en particulier, dans la gamme de longueurs d'onde du proche infrarouge allant de 800 à 1400 nm). Le coefficient d'absorption est défini par le rapport entre l'absorbance et la longueur du chemin optique parcouru par un rayonnement électromagnétique dans un milieu donné. Il s'exprime en $m^{-1}$. Il est donc indépendant de l'épaisseur du matériau mais il est fonction de la longueur d'onde du rayonnement absorbé et de la nature chimique du matériau.

Dans le cas du verre, le coefficient d'absorption ($\mu$) à une longueur d'onde λ choisie peut être calculé à partir d'une mesure en transmission (*T*) ainsi que de l'indice de réfraction n du matériau (*thick* = épaisseur), les valeurs de n, $\rho$ et T étant fonction de la longueur d'onde λ choisie :

$$\mu = -\frac{1}{thick} . ln\left[\frac{-(1-\rho)^2 + \sqrt{(1-\rho)^4 + 4.T^2.\rho^2}}{2.T.\rho^2}\right]$$

avec

$$\rho = (n\text{-}1)^2/(n\text{+}1)^2$$

En particulier, la feuille de verre V1 de l'invention a un coefficient d'absorption à la longueur d'onde λ2 inférieur à 3 m$^{-1}$. De préférence, la feuille de verre V1 a un coefficient d'absorption à la longueur d'onde λ2 inférieur à 2 m$^{-1}$, voire inférieur à 1,5 m$^{-1}$ et, de manière encore plus préférée, inférieur à 1 m$^{-1}$, voire inférieure à 0,8 m$^{-1}$.

Une solution proposée dans l'invention pour obtenir une feuille de verre très transparente à la longueur d'onde λ2 consiste à combiner dans la composition du verre une basse teneur en fer et du chrome dans une gamme de teneurs spécifiques.

Ainsi, selon un mode de réalisation de l'invention, la feuille de verre V1 a avantageusement une composition qui comprend, en une teneur exprimée en pourcentages en poids total de verre :

| | |
|---|---|
| Fer total (exprimé sous forme de $Fe_2O_3$) | 0,002 - 0,06% |
| $Cr_2O_3$ | 0,0001 - 0,06 %. |

De telles compositions de verre combinant un bas taux de fer et du chrome ont montrés des performances particulièrement bonnes en terme de transmission dans la gamme 800-1400 nm et montrent une haute transparence dans le visible et une teinte très peu marquée, proche d'un verre dit « extra-clair ». Ces compositions sont décrites dans les demandes internationales WO2014128016A1, WO2014180679A1, WO2015011040A1, WO2015011041A1, WO2015011042A1, WO2015011043A1 et WO2015011044A1, incorporées par référence dans la présente demande.

Selon ce premier mode de réalisation particulier, la composition comprend préférentiellement une teneur en chrome (exprimée sous forme de $Cr_2O_3$) allant de 0,002 à 0,06 % en poids par rapport au poids total du verre. De telles teneurs en chrome permettent d'améliorer encore la transmission dans la gamme 800-1400 nm de la feuille de verre.

Selon un autre mode de réalisation de l'invention, la feuille de verre V1 a une composition qui comprend, en une teneur exprimée en pourcentages en poids total de verre :

| | |
|---|---|
| Fer total (exprimé sous forme de $Fe_2O_3$) | 0,002 - 0,06% |
| $Cr_2O_3$ | 0,0015 - 1 % |
| Co | 0,0001 - 1%. |

De telles compositions de verre à base de chrome et de cobalt ont montré des performances particulièrement bonnes en terme de transmission dans la gamme 800-1400 nm, tout en offrant des possibilités intéressantes en terme d'esthétique/couleur. Ces compositions sont décrites dans la demande de brevet européen n°13 198 454.4, incorporée par référence dans la présente demande.

Alternativement au chrome, d'autres solutions combinant dans une composition de verre une basse teneur en fer et un ou plusieurs composants dans des teneurs spécifiques, permettent d'obtenir une feuille de verre très transparente dans la gamme 800-1400 nm, avec peu ou pas d'impact sur son esthétique et sa couleur. De telles compositions sont décrites dans la demande de brevet européen n°13 193 345.9, incorporée par référence dans la présente demande.

La feuille de verre V1 a de préférence une transmission de la longueur d'onde λ1 supérieure à 20%. De manière préférée, la feuille de verre V1 a une transmission de la longueur d'onde λ1 supérieure à 30%, voire mieux, supérieure à 40%. De manière plus préférée, la feuille de verre V1 a une transmission de la longueur d'onde λ1 supérieure à 50%, voire supérieure à 60%. De manière toute préférée, la feuille de verre V1 a une transmission de la longueur d'onde λ1 supérieure à 70%, voire supérieure à 80%. Il est bien entendu clair que plus la transmission de la feuille V1 à λ1 est grande, plus cela profitera au rendement global du dispositif de l'invention.

Avantageusement, la feuille de verre V1 a de préférence une transmission lumineuse TLA4 supérieure à 10%, voire mieux supérieure à 20%. De manière préférée, la feuille de verre V1 a une transmission lumineuse TLA4 supérieure à 30%, voire mieux, supérieure à 40%. De manière plus préférée, la feuille de verre V1 a une transmission lumineuse TLA4 supérieure à 50, voire supérieure à 60%. De manière toute préférée, la feuille de verre V1 a une transmission lumineuse TLA4 supérieure à 70%, voire supérieure à 80%. Ceci a l'avantage de permettre l'utilisation du dispositif selon l'invention comme vitrage particulièrement esthétique dans le domaine du bâtiment.

Dans le dispositif de l'invention, les cellules photovoltaïques selon l'invention peuvent être positionnées, comme illustré à la figure 1(b), (i) sur une ou plusieurs tranches de l'assemblage (C1), et/ou (ii) sur la face principale f1 (C2), et/ou (iii) sur la face principale f3 (C3).

Selon un mode de réalisation du dispositif selon l'invention, les cellules photovoltaïques sont positionnées uniquement sur une ou plusieurs tranches de l'assemblage (C1). Ceci est particulièrement avantageux afin d'obtenir un dispositif dont l'esthétique n'est pas détériorée par la vision des cellules solaires et donc valorisable en tant que vitrage architectural.

Les cellules photovoltaïques selon l'invention peuvent être avantageusement des cellules connues du type silicium cristallin ou encore du type « CIGS » ou tout autre type de cellules photovoltaïques sensibles aux longueurs d'onde $\lambda 2$.

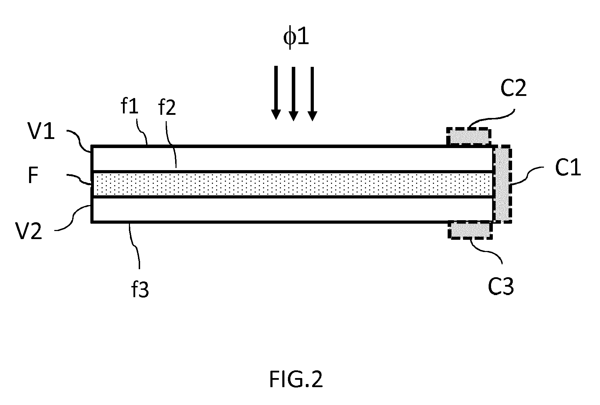

Selon un mode de réalisation de l'invention illustré à la figure 2, le dispositif comprend également une feuille de verre V2 qui recouvre la couche fonctionnelle F et qui présente un coefficient d'absorption à la longueur d'onde $\lambda 2$ inférieur à 3 m$^{-1}$. Ceci permet de rendre l'assemblage plus solide et plus pérenne, la couche fonctionnelle étant complètement protégée de l'environnement extérieur par du verre, sans entraver le bon fonctionnement du dispositif PV ni ses performances.

Dans le mode du dispositif illustré à la figure 2, les cellules photovoltaïques peuvent être positionnées (i) sur une ou plusieurs tranches de l'assemblage (C1), et/ou (ii) sur la face principale externe f1 (C2), et/ou (iii) sur la face principale externe f3 (C3). Préférentiellement, les cellules photovoltaïques sont positionnées uniquement sur une ou plusieurs tranches de l'assemblage de la figure 2 (C1).

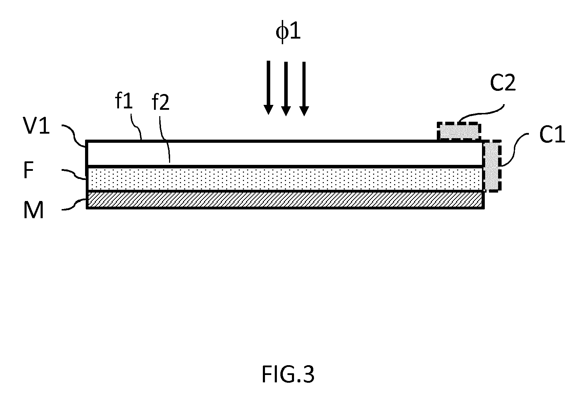

Selon un mode de réalisation de l'invention illustré à la figure 3, qui constitue une variante du mode de la figure 1, le dispositif comprend une couche miroir M recouvrant ladite couche fonctionnelle F et se situant en face externe.

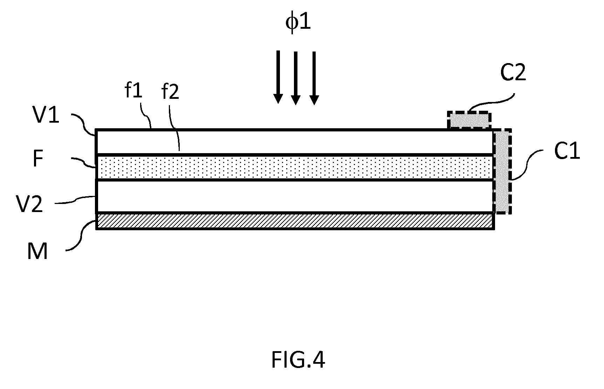

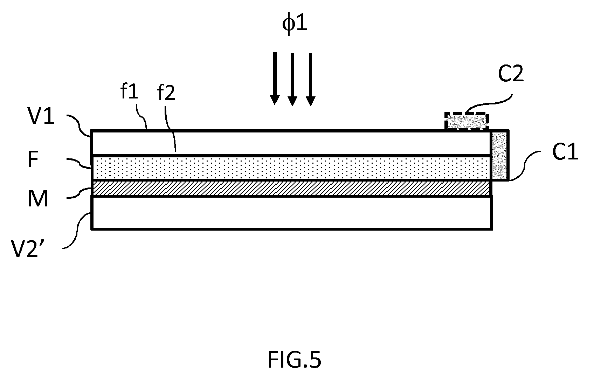

Les modes de réalisation de l'invention illustrés aux figures 4 et 5 sont respectivement des variantes des modes des figures 2 et 3.

A la figure 4, le dispositif selon l'invention comprend :

- une feuille de verre V2 qui recouvre la couche fonctionnelle F et qui présente un coefficient d'absorption à la longueur d'onde $\lambda 2$ inférieur à 3 m$^{-1}$ ; et
- une couche miroir M recouvrant ladite feuille de verre V2 et se situant en face externe.

A la figure 5, qui constitue une variante de la figure 3, le dispositif selon l'invention comprend également :

- une feuille de verre V2' ; et
- une couche miroir M recouvrant la couche fonctionnelle F et interposée entre ladite couche fonctionnelle et la feuille V2'.

La couche miroir M selon les mode de réalisation des figures 3 4 et 5 peut être par exemple un couche dite « triple argent » (Ag3) ou n'importe quelle couche réfléchissant la longueur d'onde $\lambda 2$. Ainsi, on augmente la réflexion à l'intérieur de l'assemblage et le rendement PV du dispositif en est amélioré.

Selon les modes des figures 3, 4 et 5, les cellules photovoltaïques peuvent être positionnées (i) sur une ou plusieurs tranches de l'assemblage (C1), et/ou (ii) sur la face principale externe f1 (C2). Préférentiellement, les cellules photovoltaïques sont positionnées uniquement sur une ou plusieurs tranches de l'assemblage de la figure 3, 4 ou 5 (C1).

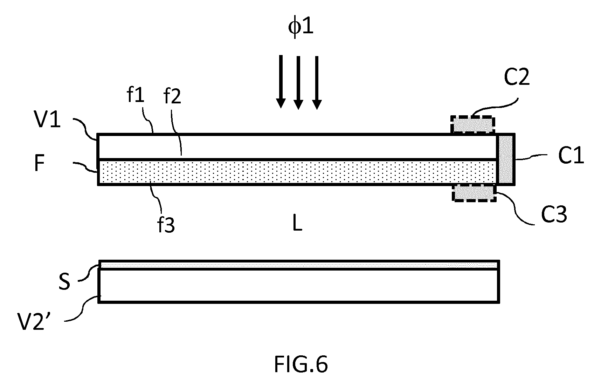

Selon un autre mode de réalisation de l'invention illustré à la figure 6, le dispositif selon l'invention constitue un vitrage multiple isolant et comprend :

- au moins une feuille de verre V2' espacée de la couche fonctionnelle F par une lame de gaz L (par exemple, d'air) ; et
- une couche S recouvrant ladite feuille de verre V2' et se situant à l'intérieur du vitrage multiple isolant du côté de la lame L, ladite couche étant une couche de contrôle solaire ou à basse émissivité (« low-e »).

Dans le mode du dispositif illustré à la figure 6, les cellules photovoltaïques peuvent être positionnées (i) sur une ou plusieurs tranches de l'assemblage (C1), et/ou (ii) sur la face principale externe f1 (C2), et/ou (iii) sur la face f3 (C3). Préférentiellement, les cellules photovoltaïques sont positionnées uniquement sur une ou plusieurs tranches de l'assemblage de la figure 6 (C1).

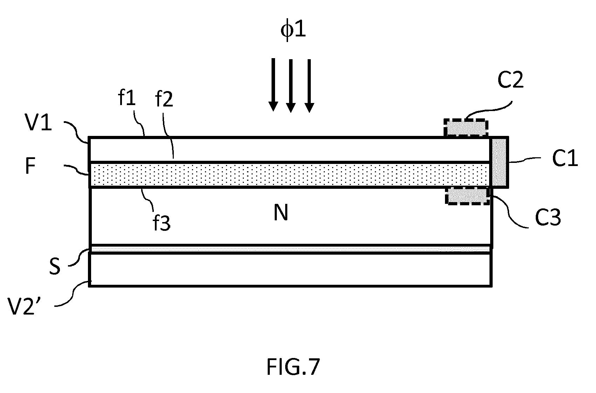

Selon un autre mode de réalisation de l'invention illustré à la figure 7, le dispositif selon l'invention comprend en outre :

- une couche N à bas indice de réfraction recouvrant la couche fonctionnelle F ;
- une couche S de contrôle solaire ou à basse émissivité (« low-e »), recouvrant la couche N à bas indice de réfraction ;

et

- une feuille de verre V2' recouvrant la couche S.

Dans le mode du dispositif illustré à la figure 7, les cellules photovoltaïques peuvent être positionnées (i) sur une ou plusieurs tranches de l'assemblage (C1), et/ou (ii) sur la face principale externe f1 (C2), et/ou (iii) sur la face f3, étant alors encapsulées dans le matériau de la couche N (C3). Préférentiellement, les cellules photovoltaïques sont positionnées uniquement sur une ou plusieurs tranches de l'assemblage de la figure 7 (C1).

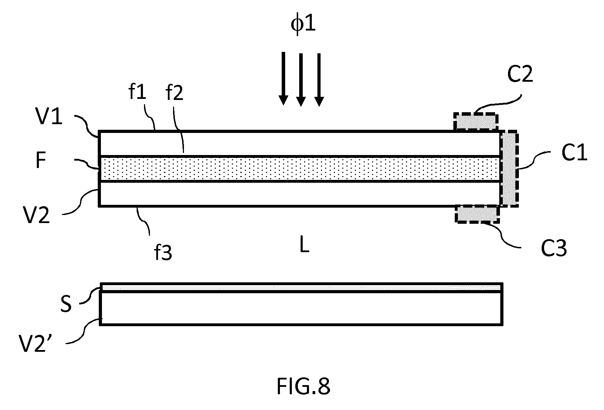

Le mode de réalisation de l'invention illustré à la figure 8 est une variante du mode de la figure 2. Selon cette variante, le dispositif constitue un vitrage multiple isolant et comprend en outre :

- une feuille de verre V2 qui recouvre la couche fonctionnelle F et qui présente un coefficient d'absorption à la longueur d'onde $\lambda 2$ inférieur à 3 m$^{-1}$.
- au moins une feuille de verre V2' espacée de la couche fonctionnelle F par une lame de gaz L (par exemple, d'air); et
- une couche S recouvrant ladite feuille de verre V2' et se situant à l'intérieur du vitrage multiple isolant du côté de la lame L ; ladite couche étant une couche de contrôle solaire ou à basse émissivité (« low-e »).

Dans les modes de réalisation des figures 2, 4 et 8, comprenant une feuille de verre V2, la feuille de verre V2 a de préférence un coefficient d'absorption à la longueur d'onde $\lambda 2$ inférieur à 2 m$^{-1}$, voire inférieur à 1,5 m$^{-1}$ et, de manière encore plus préférée, inférieur à 1 m$^{-1}$, voire inférieure à 0,8 m$^{-1}$. De plus, la feuille de verre V2 a de préférence une transmission lumineuse TLA4 supérieure à 10%, voire mieux supérieure à 20%. De manière préférée, la feuille de verre V2 a une transmission lumineuse TLA4 supérieure à 30%, voire mieux, supérieure à 40%. De manière plus préférée, la feuille de verre V2 a une transmission lumineuse TLA4 supérieure à 50, voire supérieure à 60%. De manière toute préférée, la feuille de verre V2 a une transmission lumineuse TLA4 supérieure à 70%, voire supérieure à 80%. Ceci a l'avantage de permettre l'utilisation du dispositif selon l'invention comme vitrage particulièrement esthétique dans le domaine du bâtiment. La feuille de verre V2 peut être une feuille de verre obtenue par un procédé de flottage, d'étirage, de laminage ou tout autre procédé connu pour fabriquer une feuille de verre au départ d'une composition de verre en fusion. Préférentiellement, la feuille de verre V2 est une feuille de verre flotté. La feuille de verre V2 peut avoir une épaisseur variant entre 0,1 et 25 mm. Avantageusement, la feuille de verre V2 selon l'invention peut avoir une épaisseur entre 4 et 12 mm. La feuille de verre V2 est faite de verre pouvant appartenir à diverses catégories en terme de composition de base. Le verre peut ainsi être un verre de type silico-sodo-calcique, alumino-silicate, boro-silicate,... De manière préférée, la composition de base de la feuille de verre V2 comprend en une teneur exprimée en pourcentages en poids total de verre :

| | |
|---|---|
| SiO$_2$ | 55 - 85% |
| Al$_2$O$_3$ | 0 - 30% |
| B$_2$O$_3$ | 0 - 20% |
| Na$_2$O | 0 - 25% |
| CaO | 0 - 20% |
| MgO | 0 - 15% |
| K$_2$O | 0 - 20% |
| BaO | 0 - 20%. |

De manière toute préférée, la composition de base de la feuille de verre V2 comprend en une teneur exprimée en pourcentages en poids total de verre :

| | |
|---|---|
| SiO$_2$ | 55 - 78% |
| Al$_2$O$_3$ | 0 - 18% |
| B$_2$O$_3$ | 0 - 18% |
| Na$_2$O | 0 - 20% |
| CaO | 0 - 15% |
| MgO | 0 - 10% |
| K$_2$O | 0 - 10% |
| BaO | 0 - 5% |

De manière la plus préférée, la feuille de verre V2 selon l'invention est une feuille de verre silico-sodo-calcique.

Avantageusement, selon ce mode de réalisation, la composition de base de la feuille de verre V2 comprend, en une teneur exprimée en pourcentages en poids total de verre :

| | |
|---|---|
| $SiO_2$ | 60 - 75% |
| $Al_2O_3$ | 0 - 6% |
| $B_2O_3$ | 0 - 4% |
| CaO | 0 - 15% |
| MgO | 0 - 10% |
| $Na_2O$ | 5 - 20% |
| $K_2O$ | 0 - 10% |
| BaO | 0 - 5%. |

En plus de sa composition de base, la feuille de verre V2 peut comprendre d'autres composants, de nature et de quantité adaptées en fonction de l'effet recherché.

De plus, la feuille de verre V2 peut avantageusement avoir une composition qui comprend, en une teneur exprimée en pourcentages en poids total de verre :

| | |
|---|---|
| Fer total (exprimé sous forme de $Fe_2O_3$) | 0,002 - 0,06% |
| $Cr_2O_3$ | 0,0001 - 0,06%. |

Selon ce mode de réalisation particulier, la composition de la feuille de verre V2 comprend préférentiellement une teneur en chrome (exprimée sous forme de $Cr_2O_3$) allant de 0,002 à 0,06 % en poids par rapport au poids total du verre.

La feuille de verre V2 peut également avoir une composition qui comprend, en une teneur exprimée en pourcentages en poids total de verre :

| | |
|---|---|
| Fer total (exprimé sous forme de $Fe_2O_3$) | 0,002 - 0,06% |
| $Cr_2O_3$ | 0,0015 - 1% |
| Co | 0,0001 - 1%. |

Alternativement au chrome, d'autres compositions adaptées pour la feuille de verre V2 sont décrites dans la demande de brevet européen n°13 193 345.9.

Dans les modes de réalisation des figures 2, 4 et 8, les feuilles de verre V1 et V2 peuvent avoir sensiblement la même composition ou, alternativement, elle peuvent être de compositions différentes.

Dans les modes de réalisation des figures 5, 6, 7 et 8, la feuille de verre V2' peut être une feuille de verre obtenue par un procédé de flottage, d'étirage, de laminage ou tout autre procédé connu pour fabriquer une feuille de verre au départ d'une composition de verre en fusion. Préférentiellement, la feuille de verre V2' est une feuille de verre flotté. La feuille de verre V2' peut avoir une épaisseur variant entre 0,1 et 25 mm. Avantageusement, la feuille de verre V'2 selon l'invention peut avoir une épaisseur entre 4 et 12 mm. La feuille de verre V2' est faite de verre pouvant appartenir à diverses catégories en terme de composition de base. Le verre peut ainsi être un verre de type silico-sodo-calcique, alumino-silicate, boro-silicate,...

La couche fonctionnelle F selon l'invention recouvre la seconde face principale f2 de la feuille V1 et comprend une matrice dans laquelle sont dispersés les éléments luminescents. Par « dispersés » selon l'invention, on entend que les éléments luminescents sont dissouts et/ou en suspension sous forme de particules dans la matrice.

La matrice de l'invention peut être tout type de matériau apte à permettre la dispersion des éléments luminescents et permettre son adhésion sur une feuille de verre, et même sa lamination. Il peut s'agir, par exemple, d'un plastique, comme une feuille de PVB, de PU, d'ionomère ou d'EVA. Cela peut être également une couche de type vernis transparent (clearcoat), comme par exemple, une résine époxy ou un méthacrylate.

Avantageusement, la couche fonctionnelle F selon l'invention a un coefficient d'absorption à la longueur d'onde $\lambda 2$ inférieur à 5 $m^{-1}$ et de préférence, un inférieur à 3 $m^{-1}$. De manière plus préférée, la couche fonctionnelle F selon l'invention a un coefficient d'absorption à la longueur d'onde $\lambda 2$ inférieur à 2 $m^{-1}$, voire inférieur à 1,5 $m^{-1}$ et, de manière encore plus préférée, inférieur à 1 $m^{-1}$, voire inférieure à 0,8 $m^{-1}$.

Avantageusement, la couche fonctionnelle F selon l'invention a un indice de réfraction supérieur à 1,3 ; 1,4 ; 1,5 voire 1,6 ; 1,7 ; voire même supérieur à 2. Ceci présente l'avantage de limiter la proportion de rayonnement réémis qui s'échappe du verre directement sans y être propager par réflexion totale interne.

Avantageusement, la couche fonctionnelle F a de préférence une transmission lumineuse TLA4 supérieure à 10%, voire mieux supérieure à 20%. De manière préférée, la couche fonctionnelle F a une transmission lumineuse TLA4 supérieure à 30%, voire mieux, supérieure à 40%. De manière plus préférée, la couche fonctionnelle F a une transmission lumineuse TLA4 supérieure à 50, voire supérieure à 60%. De manière toute préférée, la couche fonctionnelle F a une transmission lumineuse TLA4 supérieure à 70%, voire supérieure à 80%. Ceci a l'avantage de permettre l'utilisation du dispositif selon l'invention comme vitrage particulièrement esthétique dans le domaine du bâtiment.

Les éléments luminescents selon l'invention sont susceptibles d'absorber le rayonnement incident $\phi 1$ de longueur d'onde $\lambda 1$ et de le réémettre avec une longueur d'onde $\lambda 2$ supérieure à $\lambda 1$ et comprise entre 800 et 1400 nm.

Les éléments luminescents selon l'invention peuvent être de nature organique et/ou inorganique mais préférentiellement, de nature inorganique pour des raisons de stabilité dans le temps. Les éléments luminescents selon l'invention peuvent être (i) sous forme de particules dispersées et en suspension dans ladite matrice et/ou (ii) sous forme dissoute dans le matériau de la matrice. Lorsque les éléments luminescents sont sous forme de particules, le choix de la taille desdites particules se fera idéalement afin d'éviter un impact trop important sur l'esthétique et la transparence de l'assemblage selon l'invention. La concentration des éléments luminescents dans la matrice est choisie idéalement afin d'atteindre un équilibre entre l'impact sur l'esthétique/transparence de l'assemblage et les performances PV du dispositif, tout en tenant compte de la compatibilité des éléments luminescents et du matériau de la matrice. A titre d'exemples, des concentrations de l'ordre de 0,01% en poids à 0,5 voire 1% en poids sont déjà souvent suffisantes.

Des exemples d'éléments luminescents (EL) utilisables dans l'invention sont donnés dans le tableau suivant, mentionnant les longueurs d'onde $\lambda 1$ et $\lambda 2$ correspondantes.

La couche fonctionnelle selon l'invention peut comprendre un mélange d'éléments luminescents différents.

Selon un mode de réalisation avantageux de l'invention, la longueur d'onde $\lambda 1$ est comprise entre 280 et 380 nm. En choisissant $\lambda 1$ en dehors du visible et en particulier dans l'UV, cela permet d'éviter un rendu coloré au dispositif, ce qui n'est souvent pas souhaitable dans des applications architecturales.

**Tableau 1**

| EL | $\lambda 1$ (nm) | $\lambda 2$ (nm) |
|---|---|---|
| Oxyde d'yttrium dopé terre-rare(s) et sensibilisé ytterbium, Y2O3 :RE,Yb | ~980 | ~1000 |
| Phosphore d'yttrium dopé néodyme, YP04:Nd | 940-980 | ~1060 |
| Sulfure de zinc-cadmnium, dopé cuivre, (Zn,Cd)S :Cu | 300-550 | ~940 |

Selon un mode de réalisation avantageux de l'invention, la longueur d'onde $\lambda 1$ est comprise entre 750 et 950 nm. En choisissant $\lambda 1$ en dehors du visible et en particulier dans le proche infrarouge, cela permet d'éviter un rendu coloré au dispositif, ce qui n'est souvent pas souhaitable dans des applications architecturales.

Idéalement, la différence entre les deux longueurs d'onde $\lambda 1$ et $\lambda 2$ est suffisante afin d'éviter les phénomène de perte d'énergie du à un phénomène de réabsorption du rayonnement $\phi 2$ et, en particulier, de préférence, $(\lambda 2 - \lambda 1) \geq 20$ nm, et encore mieux, $(\lambda 2 - \lambda 1) \geq 50$ nm.

Avantageusement, la longueur d'onde $\lambda 2$ est supérieure à 900 nm si on veut éviter que $\lambda 1$ et $\lambda 2$ soit trop proches et éviter ainsi la réabsorption, lorsque $\lambda 1$ se situe dans le proche infrarouge. Avantageusement également, la longueur d'onde $\lambda 2$ est inférieure à 1200 nm car les cellules solaires commerciales classiques sont insensibles au-delà de cette longueur d'onde (Si cristallin, CIGS). Très avantageusement, la longueur d'onde $\lambda 2$ est comprise entre 900 et 1200 nm.

Le mode de réalisation combinant la longueur d'onde $\lambda 1$ comprise entre 280 et 380 nm et la longueur d'onde $\lambda 2$ comprise entre 900 et 1200 nm est intéressant.

Le mode de réalisation combinant la longueur d'onde $\lambda 1$ entre 280 et 380 nm, la longueur d'onde $\lambda 2$ comprise entre 900 et 1200 nm et $(\lambda 2 - \lambda 1) \geq 50$ nm est tout spécialement intéressant. Nous citerons le (Zn,Cd)S :Cu comme étant dès lors un choix particulièrement adapté en tant qu'élément électroluminescent dans la présente invention.

Le mode de réalisation combinant la longueur d'onde $\lambda 1$ entre 750 et 950 nm, la longueur d'onde $\lambda 2$ comprise entre 900 et 1200 nm et $(\lambda 2 - \lambda 1) \geq 50$ nm est tout spécialement intéressant aussi.

La présente invention couvre également bien entendu le cas où plusieurs rayonnements incidents $\phi 1$, $\phi 1'$, $\phi 1''$,... de longueurs d'onde $\lambda 1$, $\lambda 1'$, $\lambda 1''$,... comprises entre 280 et 1000 nm qui sont converties par des éléments luminescents en longueurs d'onde $\lambda 2$, $\lambda 2'$, $\lambda 2''$,... comprises entre 800 et 1400 nm; le dispositif comprenant alors au moins une cellule photovoltaïque sensible à $\lambda 2$, au moins une cellule photovoltaïque sensible à $\lambda 2'$, au moins une cellule photovoltaïque sensible à $\lambda 2''$,.... ; étant entendu que lesdites cellules photovoltaïques peuvent être spécifiques à une seule longueur d'onde parmi $\lambda 2$, $\lambda 2'$, $\lambda 2''$,... ou non (une cellule pouvant être sensible à plusieurs longueurs d'ondes parmi $\lambda 2$, $\lambda 2'$, $\lambda 2''$,...).

Avantageusement, selon un mode de réalisation, le dispositif de l'invention présente une transmission lumineuse globale supérieure à 10%, et de manière préférée, supérieure à 20%, voire encore mieux, supérieure à 30% ou encore supérieure à 40% De manière toute préférée, le dispositif présente une transmission lumineuse globale supérieure à 50%, 60% ou 70%, et de manière la plus préférée, supérieure à 80%. Ceci a l'avantage de permettre l'utilisation du dispositif selon l'invention comme vitrage particulièrement esthétique dans le domaine du bâtiment.

Avantageusement, on peut recouvrir extérieurement la feuille de verre V1 d'une couche ou d'un traitement anti-reflet (en face f1), permettant ainsi à un maximum de rayonnement incident de pénétrer dans le dispositif photovoltaïque.

En fonction des applications et/ou des propriétés désirées, d'autres couches/d'autres traitements peuvent être déposées/effectués sur l'une et/ou l'autre face de la(des) feuille(s) de verre du dispositif de l'invention. Par exemple, dans la cas d'une application architecturale nécessitant une protection solaire importante, le dispositif de l'invention peut être combiné avec un film semi-transparent photovoltaïque. Ceci a l'avantage de combiner le rendement du dispositif de l'invention et le rendement du film photovoltaïque tout en assurant une protection solaire adéquate sans utiliser de verre absorbant.

## Revendications

1. Dispositif photovoltaïque, destiné à convertir en électricité un rayonnement incident $\phi 1$ d'une longueur d'onde $\lambda 1$ comprise entre 280 et 1000 nm, comprenant :

   - un assemblage comprenant

     a. une feuille de verre V1 présentant deux faces principales f1 et f2, la face f1 étant celle par laquelle pénètre le rayonnement incident dans ledit assemblage et ladite feuille V1 étant transparente audit rayonnement incident $\phi 1$;
     b. une couche fonctionnelle F recouvrant la face principale f2 de la feuille V1 et comprenant une matrice dans laquelle sont dispersés des éléments luminescents susceptibles d'absorber ledit rayonnement incident $\phi 1$ de longueur d'onde $\lambda 1$ et de le réémettre avec une longueur d'onde $\lambda 2$ supérieure à $\lambda 1$ et comprise entre 800 et 1400 nm;

   - au moins une cellule photovoltaïque (C1, C2, C3, ...) sur laquelle parvient le rayonnement réémis de longueur d'onde $\lambda 2$ et qui est sensible à la longueur d'onde $\lambda 2$;

   dispositif dans lequel la feuille de verre V1 présente un coefficient d'absorption à la longueur d'onde $\lambda 2$ inférieur à 3 m$^{-1}$.

2. Dispositif photovoltaïque selon la revendication 1, **caractérisé en ce que** la longueur d'onde $\lambda 1$ est comprise entre 280 et 380 nm.

3. Dispositif photovoltaïque selon la revendication 1, **caractérisé en ce que** la longueur d'onde $\lambda 1$ est comprise entre 750 et 950 nm.

4. Dispositif photovoltaïque selon l'une des revendications précédentes, **caractérisé en ce que** : $(\lambda 2 - \lambda 1) \geq 20$ nm.

5. Dispositif photovoltaïque selon la revendication précédente, **caractérisé en ce que** : $(\lambda 2 - \lambda 1) \geq 50$ nm.

6. Dispositif photovoltaïque selon l'une des revendications précédentes, **caractérisé en ce que** lesdites cellules photovoltaïques sont positionnées uniquement sur une ou plusieurs tranches de l'assemblage.

7. Dispositif photovoltaïque selon l'une des revendications précédentes, **caractérisé en ce que** la feuille de verre V1 présente un coefficient d'absorption à la longueur d'onde $\lambda 2$ inférieur à 2 m$^{-1}$.

8. Dispositif photovoltaïque selon la revendication précédente, **caractérisé en ce que** la feuille de verre V1 présente un coefficient d'absorption à la longueur d'onde $\lambda 2$ inférieur à 1,5 m$^{-1}$.

9. Dispositif photovoltaïque selon la revendication précédente, **caractérisé en ce que** la feuille de verre V1 présente un coefficient d'absorption à la longueur d'onde $\lambda 2$ inférieur à 1 m$^{-1}$.

10. Dispositif photovoltaïque selon l'une des revendications précédentes, **caractérisé en ce que** la couche fonctionnelle F a un coefficient d'absorption à la longueur d'onde $\lambda 2$ inférieur à 5 m$^{-1}$.

φ1

f1   f2

V1

F

f3

(a)

φ1

C2

V1

F

C1

C3

(b)

FIG.1

FIG.2

FIG.3

FIG.4

φ1

C2

f1 f2

V1

F

C1

M

V2'

FIG.5

FIG.6

FIG.7

FIG.8

Europäisches Patentamt
European Patent Office
Office européen des brevets

# RAPPORT DE RECHERCHE EUROPEENNE

Numéro de la demande

EP 15 19 6313

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2013/087193 A1 (YUI HIDEOMI [JP] ET AL) 11 avril 2013 (2013-04-11) * le document en entier * ----- | 1-7 | INV. H01L31/055 |
| X | US 2010/139769 A1 (MAPEL JONATHAN K [US]) 10 juin 2010 (2010-06-10) * alinéas [0056] - [0062], [0152] - [0162]; figures 1-3,4b,19,22,23,25,27 * ----- | 1-10 | |
| A,D | WO 2014/180679 A1 (AGC GLASS EUROPE [BE]) 13 novembre 2014 (2014-11-13) * le document en entier * ----- | 1-10 | |
| A | WO 2009/011188 A1 (KONICA MINOLTA MED & GRAPHIC [JP]; AIMIYA TAKUJI [JP]; OKADA HISATAKE) 22 janvier 2009 (2009-01-22) * le document en entier * ----- | 1-10 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| Berlin | 27 avril 2016 | Voignier, Vincent |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.......................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 15 19 6313

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-04-2016

| Document brevet cité au rapport de recherche | Date de publication | Membre(s) de la famille de brevet(s) | Date de publication |
|---|---|---|---|
| US 2013087193 A1 | 11-04-2013 | CN 102986036 A<br>JP 5292515 B2<br>US 2013087193 A1<br>WO 2011158568 A1 | 20-03-2013<br>18-09-2013<br>11-04-2013<br>22-12-2011 |
| US 2010139769 A1 | 10-06-2010 | AUCUN | |
| WO 2014180679 A1 | 13-11-2014 | CN 105189388 A<br>EP 2994433 A1<br>KR 20160005041 A<br>TW 201504181 A<br>US 2016083291 A1<br>WO 2014180679 A1 | 23-12-2015<br>16-03-2016<br>13-01-2016<br>01-02-2015<br>24-03-2016<br>13-11-2014 |
| WO 2009011188 A1 | 22-01-2009 | AUCUN | |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- EP 0004242 B1
- DE 2628291
- US 4127425 A
- EP 0004242 B
- US 4727425 A
- WO 2014128016 A1
- WO 2014180679 A1
- WO 2015011040 A1
- WO 2015011041 A1
- WO 2015011042 A1
- WO 2015011043 A1
- WO 2015011044 A1
- EP 13198454 A
- EP 13193345 A

**Littérature non-brevet citée dans la description**

- **E. WEBER ; J. LAMBE.** *Applied Optics,* vol. 15 (10), 2299-2300